(19)

Europäisches
Patentamt
European
Patent Office
Office européen
des brevets

(11)     EP 2 109 002 A2

(12)     EUROPEAN PATENT APPLICATION

(43) Date of publication:
14.10.2009 Bulletin 2009/42

(51) Int Cl.:
G03F 7/20 (2006.01)

(21) Application number: 09156420.3

(22) Date of filing: 27.03.2009

(84) Designated Contracting States:
AT BE BG CH CY CZ DE DK EE ES FI FR GB GR
HR HU IE IS IT LI LT LU LV MC MK MT NL NO PL
PT RO SE SI SK TR
Designated Extension States:
AL BA RS

(30) Priority: 10.04.2008 JP 2008102561

(71) Applicant: Canon Kabushiki Kaisha
Tokyo 146-8501 (JP)

(72) Inventor: Kuramoto, Yoshiyuki
Tokyo 146-8501 (JP)

(74) Representative: TBK-Patent
Bavariaring 4-6
80336 München (DE)

(54) **Measurement method, measurement apparatus, exposure apparatus, and device fabrication method**

(57)    The present invention provides a measurement method of measuring imaging performance of a projection optics which projects a reticle pattern onto a substrate, including a measurement step of measuring the imaging performance of the projection optics, and a calculation step of calculating the imaging performance of the projection optics in a predetermined environment different from a measurement environment in which the measurement step is performed, based on information indicating a rate of change of the imaging performance of the projection optics with respect to a physical quantity which changes the imaging performance of the projection optics, a physical quantity in the measurement environment, a physical quantity in the predetermined environment, and the imaging performance of the projection optics measured in the measurement step.

F I G. 1

EP 2 109 002 A2

**Description**

BACKGROUND OF THE INVENTION

Field of the Invention

The present invention relates to a measurement method, measurement apparatus, exposure apparatus, and device fabrication method.

Description of the Related Art

A projection exposure apparatus has been conventionally used when fabricating fine semiconductor devices such as a semiconductor memory and logic circuit by using the photolithography technique. In this projection exposure apparatus, a projection optics (projection optical system) projects a circuit pattern formed on a reticle (photomask) onto a substrate such as a wafer, thereby transferring the circuit pattern.

Recently, the projection exposure apparatus is required to accurately transfer a reticle pattern onto a wafer at a predetermined magnification because micropatterning of semiconductor devices is further advancing. Therefore, it is important to use a projection optics having high imaging performance, and necessary to accurately measure the imaging performance (e.g., the wavefront aberration) of a projection optics.

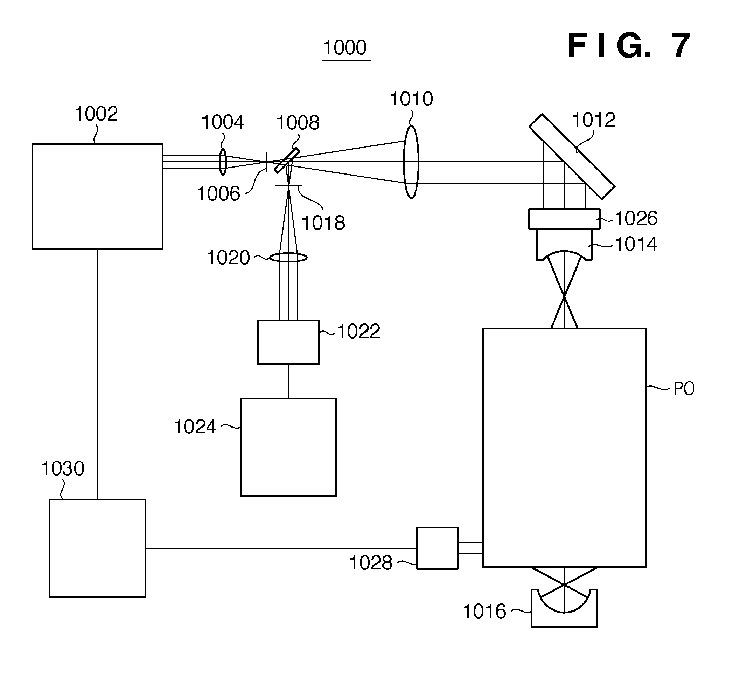

Fig. 7 is a view showing the arrangement of a conventional measurement apparatus 1000 for measuring the imaging performance of a projection optics PO. Referring to Fig. 7, a light beam emitted by a light source 1002 passes through a wavefront shaping pinhole 1006 for shaping the transmission wavefront via a condenser lens 1004. The light beam having passed through the wavefront shaping pinhole 1006 is transmitted through a half mirror 1008 while diffusing, and collimated into a parallel beam through a collimator lens 1010. The light beam having passed through the collimator lens 1010 enters a TS lens 1014 via a retroreflector 1012. The radius of curvature of the final surface of the TS lens 1014 is equal to the distance to its focal point. A part of the light beam is reflected by the final surface of the TS lens 1014, and the rest of the light beam is transmitted through the TS lens 1014 and enters the projection optics PO. The light beam reflected by the final surface of the TS lens 1014 will be referred to as a reference light beam hereinafter.

The light beam having passed through the projection optics PO is reflected by an RS mirror 1016 via the projection optics PO. The center of curvature of the RS mirror 1016 is set in a position optically conjugated to the focal point of the TS lens 1014. The light beam reflected by the RS mirror 1016 passes through the same optical path as that of the forward propagation in the projection optics PO, and is transmitted through the TS lens 1014. The light beam reflected by the RS mirror 1016 and transmitted through the TS lens 1014 via the projection optics PO will be referred to as a light beam to be detected hereinafter.

The reference light beam and the light beam to be detected are reflected by the half mirror 1008, pass through a spatial filter 1018, and enter an image sensing element 1022 after being collimated into parallel light beams by a pupil imaging lens 1020. Since the reference light beam and the light beam to be detected interfere with each other on the image sensing element 1022, the image sensing element 1022 takes an image of the interference pattern corresponding to the wavefront aberration of the projection optics PO.

A calculator 1024 controls the optical path length difference between the light beam to be detected and the reference light beam via a piezoelectric element 1026 for driving the TS lens 1014. The calculator 1024 also calculates the wavefront aberration of the projection optics PO by phase retrieval from images (interference patterns) obtained for a plurality of optical path length differences by the image sensing element 1022.

Note that the wavefront aberration of the projection optics PO changes in accordance with an environment in which the projection optics PO is installed, or the state of the projection optics PO (e.g., the position of an optical element forming the projection optics PO). For example, the wavefront aberration of the projection optics PO changes in accordance with the atmospheric pressure. Even when the internal atmospheric pressure of the projection optics PO fluctuates, therefore, it is necessary to measure the wavefront aberration of the projection optics PO at a predetermined atmospheric pressure (i.e., at the atmospheric pressure of an exposure environment (exposure state)). Accordingly, a controller 1030 adjusts the wavelength of the light beam emitted from the light source 1002 based on the internal atmospheric pressure of the projection optics PO, which is detected by a barometer 1028, and obtains, in a pseudo manner, a state in which the wavefront aberration of the projection optics PO at the predetermined atmospheric pressure is measured. This makes it possible to measure the wavefront aberration of the projection optics PO at the predetermined atmospheric pressure (i.e., the wavefront aberration of the projection optics PO in the exposure environment), regardless of the fluctuation in internal atmospheric pressure of the projection optics PO.

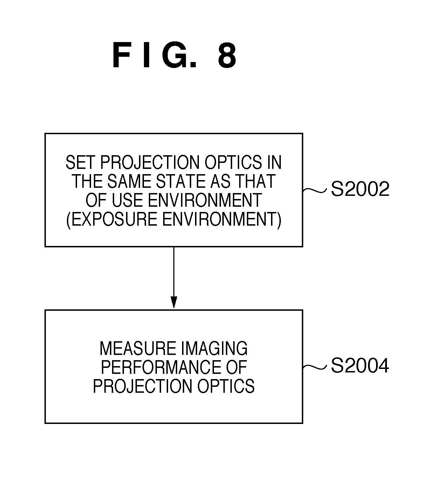

When measuring the imaging performance of the projection optics, therefore, as shown in Fig. 8, it is necessary to first set the projection optics in the same state as that of the use environment (exposure environment) (step S2002), and then measure the imaging performance of the projection optics in this state (step S2004). This matches the imaging performance of the projection optics measured by the measurement apparatus 1000 with that of the projection optics in the exposure environment.

A technique of measuring (correcting) the imaging performance of the projection optics (optical system to be detected) as described above is disclosed in Japanese Patent Laid-Open No. 1-123238.

Unfortunately, the conventional technique that measures the imaging performance by setting the projection optics in the same state as that of the use environment (exposure environment) is beginning to pose the following problems as the accuracy of the exposure apparatus increases.

For example, as the accuracy of the exposure apparatus increases, parameters settable in the exposure apparatus (projection optics) are complicated, and this makes it very difficult to reproduce the same state as that of the exposure environment in the measurement apparatus. Accordingly, it takes a long time to reproduce the same state as that of the exposure environment, and a long time to measure the imaging performance of the projection optics. Also, the measurement accuracy decreases if the same state as that of the exposure environment cannot be reproduced.

Furthermore, even when the projection optics is controlled in the same state as that of the exposure environment in the measurement apparatus, the measurement accuracy decreases if a control error (e.g., a driving error of a lens forming the projection optics) causes a measurement error.

SUMMARY OF THE INVENTION

The present invention provides a measurement method and measurement apparatus capable of accurately measuring the imaging performance of a projection optics in the use environment (exposure environment).

The present invention in its first aspect provides a measurement method as specified in claims 1 to 7.

The present invention in its second aspect provides a measurement apparatus as specified in claims 8 and 9.

The present invention in its third aspect provides an exposure apparatus as specified in claim 10.

The present invention in its fourth aspect provides a device fabrication method as specified in claim 11.

Further aspects and features of the present invention will become apparent from the following description of exemplary embodiments with reference to the attached drawings.

BRIEF DESCRIPTION OF THE DRAWINGS

Fig. 1 is a view showing the arrangement of a measurement apparatus according to the first embodiment of the present invention.

Fig. 2 is a flowchart showing details of a method of measuring the imaging performance of projection optics in the measurement apparatus shown in Fig. 1.

Fig. 3 is a view showing the arrangement of a measurement apparatus according to the second embodiment of the present invention.

Fig. 4 is a flowchart showing details of a method of measuring the imaging performance of projection optics in the measurement apparatus shown in Fig. 3.

Fig. 5 is a view showing the arrangement of an exposure apparatus according to the third embodiment of the present invention.

Fig. 6 is a flowchart showing details of a method of measuring the wavefront aberration of projection optics in the exposure apparatus.

Fig. 7 is a view showing the arrangement of a conventional measurement apparatus.

Fig. 8 is a flowchart for explaining a conventional measurement method.

DESCRIPTION OF THE EMBODIMENTS

Preferred embodiments of the present invention will be explained below with reference to the accompanying drawings. Note that the same reference numerals denote the same parts in these drawings, and a repetitive explanation will be omitted.

[First Embodiment]

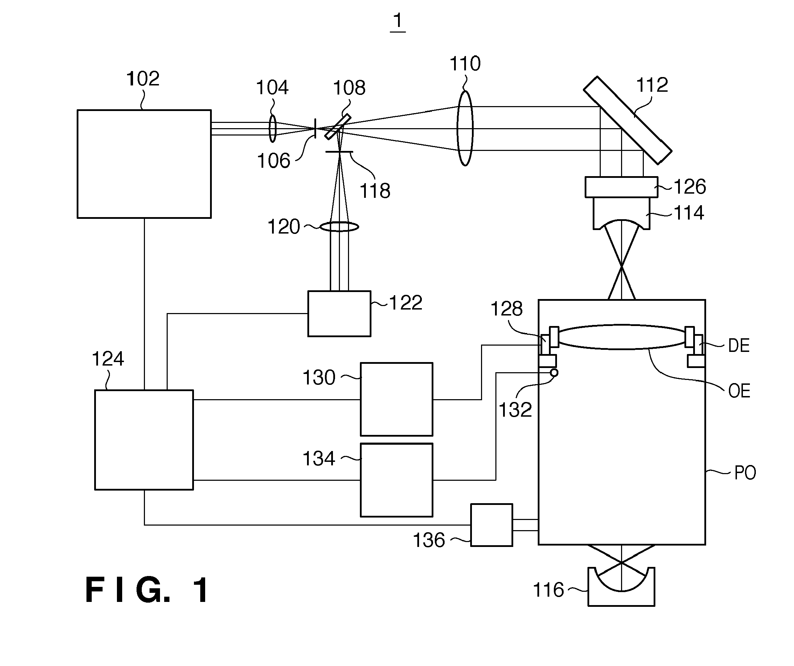

Fig. 1 is a view showing the arrangement of a measurement apparatus 1 according to the first embodiment of the present invention. In this embodiment, the measurement apparatus 1 measures the imaging performance of a projection optics (projection optical system) in the use environment (a predetermined environment such as an exposure environment in which a reticle pattern is transferred onto a substrate). Note that a projection optics PO as a measurement object (i.e., an optical system to be detected) of the measurement apparatus 1 has a driving element DE for driving an optical element OE with respect to the reference plane of a barrel of the projection optics PO in order to adjust (optimize) the imaging performance in the exposure environment.

As shown in Fig. 1, the measurement apparatus 1 includes a light source 102, condenser lens 104, wavefront shaping pinhole 106, half mirror 108, collimator lens 110, retroreflector 112, TS lens 114, and RS mirror 116. The measurement apparatus 1 also includes a spatial filter 118, pupil imaging lens 120, image sensing element 122, calculator 124, piezoelectric element 126, encoder 128, optical element controller 130, thermometer 132, thermometer amplifier 134, and pressure gauge 136.

In the measurement apparatus 1, constituent elements except for the encoder 128, optical element controller 130, thermometer 132, thermometer amplifier 134, and pressure gauge 136 function as a measurement unit for measuring the imaging performance of the projection optics PO.

The light source 102 has a function of emitting a light beam (measurement light) for measuring the imaging performance of the projection optics PO, a function of detecting the wavelength of the light beam, and a function of transmitting the detected wavelength of the light beam to the calculator 124.

The encoder 128 detects the displacement (the position or attitude with respect to the reference plane of the barrel of the projection optics PO) of the optical element OE in the projection optics PO. The encoder 128 inputs the detection result to the optical element controller 130. The optical element controller 130 controls the driving element DE as needed, and transmits position information of the optical element OE to the calculator 124.

The thermometer 132 detects the internal temperature (in the barrel) of the projection optics PO. The thermometer 132 transmits the detection result to the calculator 124 via the thermometer amplifier 134.

The pressure gauge 136 detects the internal pressure (in the barrel) of the projection optics PO. The pressure gauge 136 transmits the detection result to the calculator 124.

Referring to Fig. 1, the light beam emitted by the light source 102 passes through the wavefront shaping pinhole 106 for shaping the transmission wavefront via the condenser lens 104. The light beam having passed through the wavefront shaping pinhole 106 is transmitted through the half mirror 108 while diffusing, and collimated into a parallel beam through the collimator lens 110.

The light beam having passed through the collimator lens 110 enters the TS lens 114 via the retroreflector 112. The radius of curvature of the final surface of the TS lens 114 is equal to the distance to its focal point. Note that the retroreflector 112 and TS lens 114 are arranged on stages driven in synchronism with each other.

A part of the light beam is reflected by the final surface of the TS lens 114, and the rest of the light beam is transmitted through the TS lens 114 and enters the projection optics PO. The light beam reflected by the final surface of the TS lens 114 will be referred to as a reference light beam hereinafter.

The light beam having passed through the projection optics OP is reflected by the RS mirror 116 via the projection optics PO. The center of curvature of the RS mirror 116 is set in a position optically conjugated to the focal point of the TS lens 114. The light beam reflected by the RS mirror 116 passes through the same optical path as that of the forward propagation in the projection optics PO, and is transmitted through the TS lens 114. The light beam reflected by the RS mirror 116 and transmitted through the TS lens 114 via the projection optics PO will be referred to as a light beam to be detected hereinafter.

The reference light beam and the light beam to be detected are reflected by the half mirror 108, pass through the spatial filter 118, and enter the image sensing element 122 after being collimated into parallel light beams by the pupil imaging lens 120. Since the reference light beam and the light beam to be detected interfere with each other on the image sensing element 122, the image sensing element 122 takes an image of the interference pattern corresponding to the wavefront aberration of the projection optics PO.

A method of measuring the imaging performance of the projection optics PO in the measurement apparatus 1 will be explained below. In this embodiment, the calculator 124 calculates (measures) the imaging performance of the projection optics PO by executing a calculating process to be explained below. Note that the calculator 124 of this embodiment includes a CPU and memory (not shown), and also has the function of a controller for controlling the whole (operation) of the measurement apparatus 1.

The calculator 124 controls the optical path length difference between the light beam to be detected and the reference light beam via the piezoelectric element 126 for driving the TS lens 114, and acquires interference patterns (captured images) obtained by a plurality of optical path length differences from the image sensing element 122. That is, in synchronism with capture of the interference patterns obtained by the plurality of optical path length differences, the light source 102 and encoder 128 respectively detect the wavelength of the light beam emitted from the light source 102 and the displacement of the optical element OE in the projection optics PO. Likewise, in synchronism with capture of the interference patterns obtained by the plurality of optical path length differences, the thermometer 132 and pressure gauge 136 respectively detect the internal temperature and pressure of the projection optics PO. The calculator 124 acquires the wavelength of the light beam emitted from the light source 102, the displacement of the optical element OE in the projection optics PO, and the internal temperature and pressure of the projection optics PO, all of which are detected in synchronism with capture of the interference patterns obtained by the plurality of optical path length differences.

In this embodiment, the calculator 124 calculates the wavefront aberration, distortion, and image field deviation as the imaging performance of the projection optics PO. As disclosed in Japanese Patent Laid-Open No. 1-123238, the imaging performance can be calculated based on the focal point of the TS lens 114 and the center of curvature of the RS mirror 116, both of which are detected in synchronism with measurement of the wavefront aberration performed by fringe scan.

By performing the above processing at N image heights of the TS lens 114 and RS mirror 116, the calculator 124 can calculate the imaging performance of the projection optics PO as indicated by

(Equation 1)

$$Wf(Wx(i), Wy(i)) = \Sigma j Zj(i) \quad (j = 1, 2, ..., 36)$$

$$dX(Wx(i), Wy(i)) = dX(i)$$

$$dY(Wx(i), Wy(i)) = dY(i)$$

$$dZ(Wx(i), Wy(i)) = dZ(i)$$

$$i = 1, 2, ..., N$$

where $Wx(i)$ and $Wy(i)$ indicate the ith measurement image height, and $Wf$ indicates the measurement result of the wavefront aberration of the projection optics PO. $\Sigma j$ indicates a sum for an index variable j, and $Z1(i)$ to $Z36(i)$ indicate Zernike coefficients of the measurement result of the wavefront aberration at the ith measurement image height. This embodiment uses Zernike coefficients of 36 terms. $dX(i)$ and $dY(i)$ respectively indicate distortions in the X direction and Y direction at the ith measurement image height. $dZ(i)$ indicates the image field deviation at the ith measurement image height.

As described above, the calculator 124 receives the information (e.g., the wavelength of the light beam emitted by the light source 102, and the internal temperature and pressure of the projection optics PO) indicating the measurement environment, and the displacement of the optical element OE in the projection optics PO. These physical quantities change (i.e., affect) the imaging performance of the projection optics PO. Generally, physical quantities in the measurement environment are different from those in the use environment (exposure environment) of the projection optics PO. Accordingly, the imaging performance of the projection optics PO calculated by equation 1 is different from that of the projection optics PO in the exposure environment. In this embodiment, therefore, the calculator 124 corrects changes in imaging performance of the projection optics PO caused by the physical quantities that change the imaging performance, and accurately calculates the imaging performance of the projection optics PO in the exposure environment. For example, based on information indicating the rate of change of the imaging performance of the projection optics PO, which corresponds to the physical quantities that change the imaging performance, the physical quantities in the exposure environment, and the physical quantities in the measurement environment, the calculator 124 calculates the imaging performance of the projection optics PO in the exposure environment as indicated by

(Equation 2)

$$Wf(Wx(i),Wy(i)) = \Sigma j\{Zj(i) - dZj(i)/dP(P0 - P(i))$$

$$- dZj(i)/d\lambda(\lambda0 - \lambda(i)) - dZj(i)/dT(T0 - T(i)) -$$

$$dZj(i)/dr(r0 - r(i))\} \qquad (j = 1, 2,..., 36)$$

$$dX(Wx(i),Wy(i)) = dX(i) - dX(i)/dP(P0 - P(i)) -$$

$$dX(i)/d\lambda(\lambda0 - \lambda(i)) - dX(i)/dT(T0 - T(i)) - dX(i)/dr(r0$$

$$- r(i))$$

$$dY(Wx(i),Wy(i)) = dY(i) - dY(i)/dP(P0 - P(i)) -$$

$$dY(i)/d\lambda(\lambda0 - \lambda(i)) - dY(i)/dT(T0 - T(i)) - dY(i)/dr(r0$$

$$- r(i))$$

$$dZ(Wx(i),Wy(i)) = dZ(i) - dZ(i)/dP(P0 - P(i)) -$$

$$dZ(i)/d\lambda(\lambda0 - \lambda(i)) - dZ(i)/dT(T0 - T(i)) - dZ(i)/dr(r0$$

$$- r(i))$$

where P0, λ0, T0, and r0 respectively indicate ideal values of the internal atmospheric pressure of the projection optics PO, the wavelength of the light beam emitted by the light source 102, the internal temperature of the projection optics PO, and the displacement of the optical element OE in the projection optics PO. In other words, P0, λ0, T0, and r0 indicate the physical quantities in the exposure environment.

Also, P(i), λ(i), T(i), and r(i) respectively indicate the internal atmospheric pressure of the projection optics PO, the wavelength of the light beam emitted from the light source 102, the internal temperature of the projection optics PO, and the displacement of the optical element OE in the projection optics PO, all of which are detected when performing measurement at the ith measurement image height. In other words, P(i), λ(i), T(i), and r (i) indicate the physical quantities in the measurement environment. Note that the displacement r of the optical element OE includes six degrees of freedom of changes in position and attitude of the optical element OE in the projection optics PO.

Furthermore, dZj(i)/dP indicates the sensitivity of the Zernike coefficients of the jth term at the ith measurement image height with respect to the internal atmospheric pressure of the projection optics PO (i.e., the information indicating the rate of change of the imaging performance). Also, dZj(i)/dλ, dZj(i)/dT and dZj(i)/dr respectively indicate the sensitivities of the Zernike coefficients of the jth term at the ith measurement image height with respect to the wavelength of the light beam emitted by the light source 102, the internal temperature of the projection optics PO, and the displacement of the optical element OE in the projection optics PO. Note that similar symbols indicate the sensitivities to the distortion and image field deviation. These sensitivities (information indicating the rate of change of the imaging performance) are precalculated by an optical CAD or the like by using design values of the projection optics PO, and prestored in a storage unit such as a memory (not shown) of the calculator 124. If the sensitivity cannot be calculated from the design values of the projection optics PO (or if the calculation accuracy is insufficient), it is also possible to actually measure the imaging performance of the projection optics PO in a plurality of different measurement environments, and calculate the sensitivity based on the measurement results.

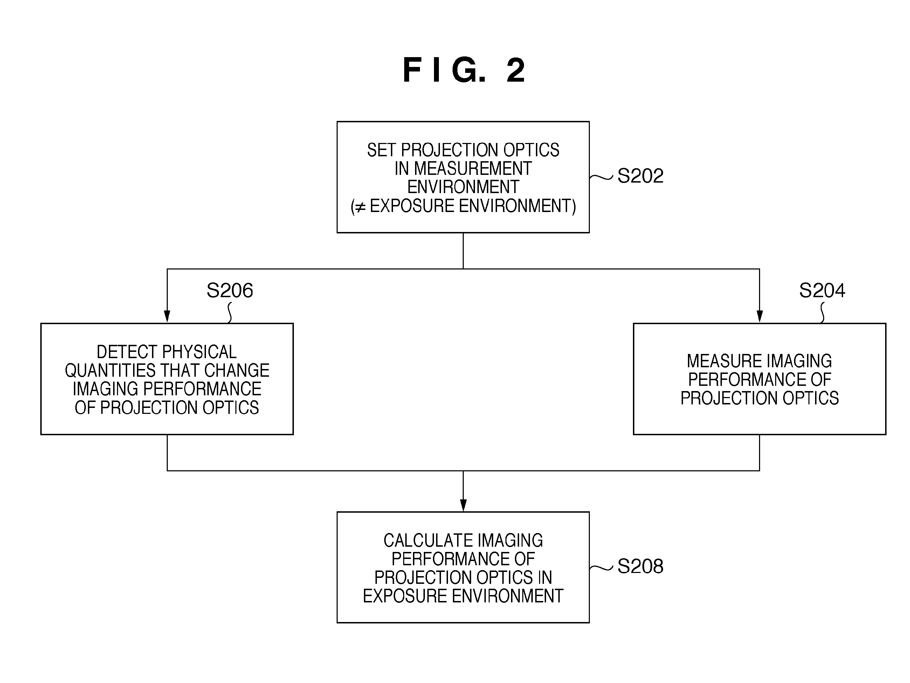

Fig. 2 is a flowchart showing details of the method of measuring the imaging performance of the projection optics PO in the measurement apparatus 1.

First, in step S202, the projection optics PO is controlled in a measurement environment corresponding to the measurement conditions of the measurement apparatus 1. Note that the measurement environment corresponding to the measurement conditions of the measurement apparatus 1 does not always match the use environment (exposure environment) of the projection optics PO.

Then, in step S204, the imaging performance of the projection optics PO is measured in the measurement environment controlled in step S202. Also, in step S206, the physical quantities that change the imaging performance of the projection optics PO (i.e., the physical quantities in the measurement environment) are detected in the measurement environment controlled in step S202. More specifically, the wavelength of the light beam emitted by the light source 102, the internal temperature and pressure of the projection optics PO, the position of the optical element OE in the projection optics PO, and the like are detected as described previously as the physical quantities in the measurement environment.

Subsequently, in step S208, the imaging performance measured in step S204 is corrected based on the physical quantities in the measurement environment detected in step S206, preobtained physical quantities in the exposure environment, and the sensitivity to the preobtained physical quantities. In other words, the imaging performance of the projection optics PO in the exposure environment is calculated in accordance with equation 2. More specifically, the change amount of the imaging performance of the projection optics PO in the measurement environment from that of the projection optics PO in the exposure environment is calculated based on the differences between the physical quantities in the measurement environment and those in the exposure environment as described previously. The imaging performance of the projection optics PO in the exposure environment is calculated by adding or subtracting the change amount to or from the imaging performance of the projection optics PO measured in the measurement environment.

In this embodiment as described above, the imaging performance of the projection optics PO can be measured without any complicated control for reproducing the same state as that of the exposure environment in the measurement apparatus 1, and without being influenced by, e.g., the measurement environment (environmental fluctuation). Accordingly, this embodiment can accurately measure the imaging performance of the projection optics PO in the use environment (exposure environment) within a short time.

[Second Embodiment]

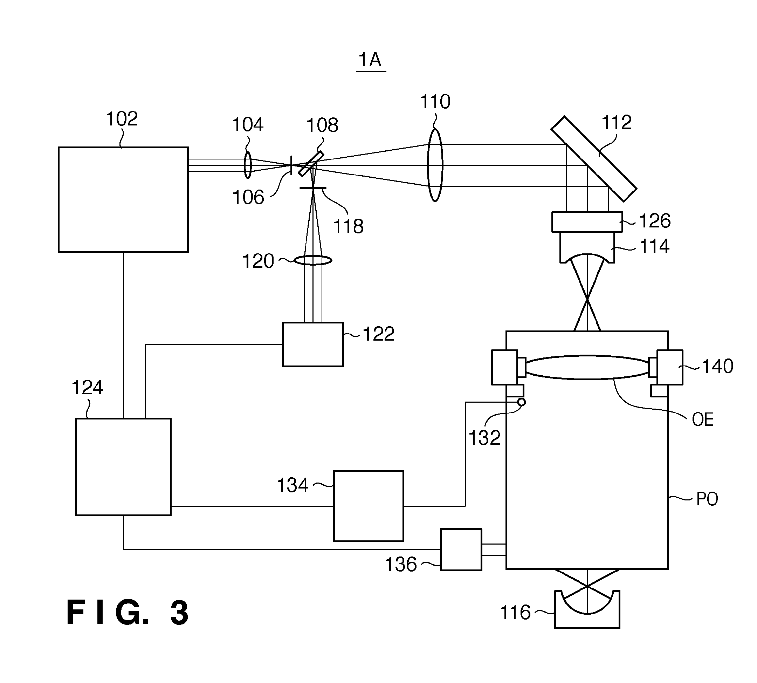

Fig. 3 is a view showing the arrangement of a measurement apparatus 1A according to the second embodiment of the present invention. In this embodiment, the measurement apparatus 1A measures the imaging performance of a projection optics in the use environment (exposure environment). Note that in this embodiment, a projection optics PO as a measurement object (i.e., an optical system to be detected) of the measurement apparatus 1A has no driving element DE for driving an optical element OE with respect to the reference plane of a barrel of the projection optics PO.

The measurement apparatus 1A includes a light source 102, condenser lens 104, wavefront shaping pinhole 106, half mirror 108, collimator lens 110, retroreflector 112, TS lens 114, and RS mirror 116. The measurement apparatus 1A also includes a spatial filter 118, pupil imaging lens 120, image sensing element 122, calculator 124, piezoelectric element 126, thermometer 132, thermometer amplifier 134, pressure gauge 136, and holding unit 140.

The holding unit 140 holds the optical element OE forming the projection optics PO and fixes the optical element OE in a predetermined position (i.e., a constant position) with respect to the barrel (reference plane) of the projection optics PO. Since the displacement of the optical element OE held and fixed by the holding unit 140 is constant, therefore, the measurement apparatus 1A need not have any mechanism for detecting the displacement of the optical element OE. In other words, the displacement of the optical element OE held and fixed by the holding unit 140 can be used as a physical quantity that changes the imaging performance of the projection optics PO. Note that the displacement of the optical element OE held and fixed by the holding unit 140 is premeasured and prestored in, for example, a storage unit such as a memory (not shown) of the calculator 124.

As described above, the measurement apparatus 1A requires neither a mechanism (encoder 128) for detecting the displacement of the optical element OE, nor a control system (optical element controller 130) for driving the optical element OE of the projection optics PO. This realizes a simple arrangement.

The calculator 124 receives information (the wavelength of a light beam emitted from the light source 102, and the internal temperature and pressure of the projection optics PO) indicating the measurement environment. As described above, the displacement of the optical element OE in the projection optics PO is prestored in the memory of the calculator 124. Based on information indicating the rate of change of the imaging performance of the projection optics PO, which corresponds to physical quantities that change the imaging performance, the physical quantities in the exposure environment, and the physical quantities in the measurement environment, the calculator 124 calculates the imaging performance of the projection optics PO in the exposure environment as indicated by

(Equation 3)

$$Wf(Wx(i),Wy(i)) = \Sigma j\{Zj(i) - dZj(i)/dP(P0 - P(i))$$

$$- dZj(i)/d\lambda(\lambda 0 - \lambda(i)) - dZj(i)/dT(T0 - T(i)) -$$

$$dZj(i)/dr(r0 - rtool)\} \qquad (j = 1, 2,..., 36)$$

$$dX(Wx(i),Wy(i)) = dX(i) - dX(i)/dP(P0 - P(i)) -$$

$$dX(i)/d\lambda(\lambda 0 - \lambda(i)) - dX(i)/dT(T0 - T(i)) - dX(i)/dr(r0$$

$$- rtool)$$

$$dY(Wx(i),Wy(i)) = dY(i) - dY(i)/dP(P0 - P(i)) -$$

$$dY(i)/d\lambda(\lambda 0 - \lambda(i)) - dY(i)/dT(T0 - T(i)) - dY(i)/dr(r0$$

$$- rtool)$$

$$dZ(Wx(i),Wy(i)) = dZ(i) - dZ(i)/dP(P0 - P(i)) -$$

$$dZ(i)/d\lambda(\lambda 0 - \lambda(i)) - dZ(i)/dT(T0 - T(i)) - dZ(i)/dr(r0$$

$$- rtool)$$

where rtool indicates the displacement of the optical element OE held and fixed by the holding unit 140.

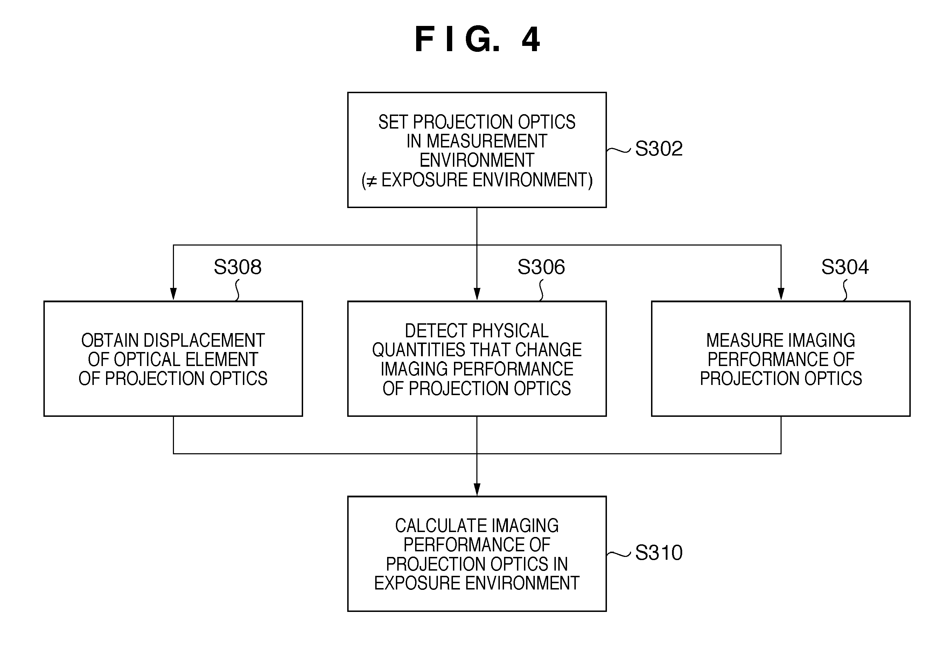

Fig. 4 is a flowchart showing details of the method of measuring the imaging performance of the projection optics PO in the measurement apparatus 1A.

First, in step S302, the projection optics PO is controlled to attain a measurement environment corresponding to the measurement conditions of the measurement apparatus 1A. Note that the measurement environment corresponding to the measurement conditions of the measurement apparatus 1A does not always match the use environment (exposure environment) of the projection optics PO.

Then, in step S304, the imaging performance of the projection optics PO is measured in the measurement environment controlled in step S302. Also, in step S306, the physical quantities that change the imaging performance of the projection optics PO (i.e., the physical quantities in the measurement environment) are detected in the measurement environment controlled in step S302. More specifically, the wavelength of the light beam emitted from the light source 102, the internal temperature and pressure of the projection optics PO, and the like are detected as the physical quantities in the measurement environment as described previously. In addition, in step S308, the displacement of the optical element OE held and fixed by the holding unit 140 (i.e., the physical quantity not detected in step S306) is acquired from the memory of the calculator 124.

Subsequently, in step S310, the imaging performance of the projection optics PO measured in step S304 is corrected. More specifically, the imaging performance measured in step S304 is corrected based on the physical quantities in the measurement environment detected and acquired in steps S306 and S308, preobtained physical quantities in the exposure environment, and the sensitivity to the preobtained physical quantities. In other words, the imaging performance of the projection optics PO in the exposure environment is calculated in accordance with equation 3.

In this embodiment as described above, the imaging performance of the projection optics PO can be measured without any complicated control for reproducing the same state as that of the exposure environment in the measurement apparatus 1A, and without being influenced by, e.g., the measurement environment (environmental fluctuation). Accordingly, this embodiment can accurately measure the imaging performance of the projection optics PO in the use environment (exposure environment) within a short time.

[Third Embodiment]

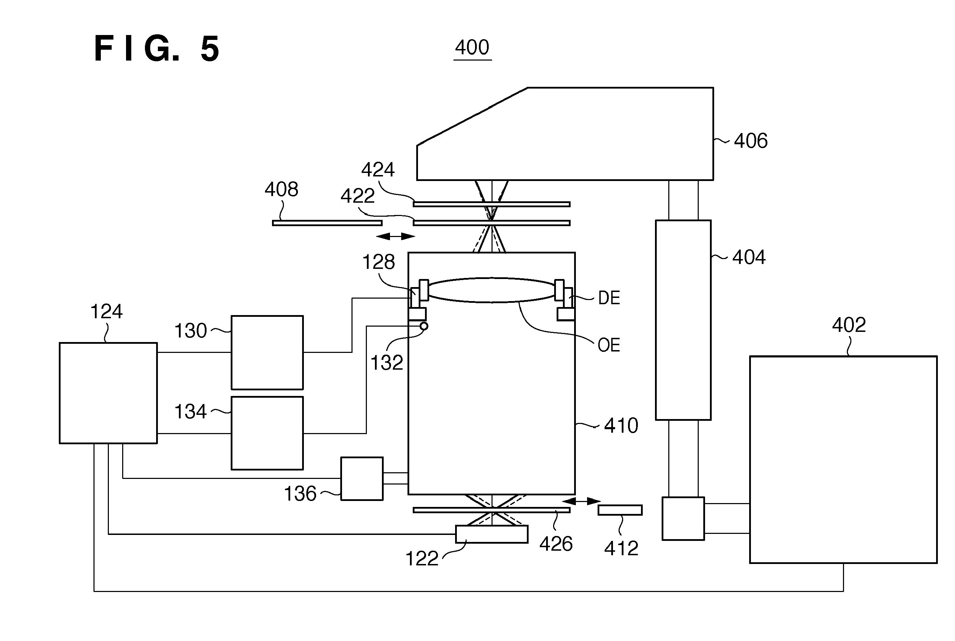

Fig. 5 is a view showing the arrangement of an exposure apparatus 400 according to the third embodiment of the present invention. In this embodiment, an example of the case in which the exposure apparatus 400 executes the method of measuring the imaging performance of a projection optics in the first and second embodiments will be explained below.

The exposure apparatus 400 is a projection exposure apparatus that transfers a reticle pattern onto a substrate such as a wafer by the step-and-scan method, step-and-repeat method, or another exposure method.

As shown in Fig. 5, the exposure apparatus 400 includes an exposure light source 402, incoherent optics 404, illumination optics 406, projection optics 410, object plane side measurement mask 422, and diffraction grating 424. The exposure apparatus 400 also includes an image plane side measurement mask 426, image sensing element 122, calculator 124, encoder 128, optical element controller 130, thermometer 132, thermometer amplifier 134, and pressure gauge 136.

The exposure light source 402 has a function of emitting a light beam, a function of detecting the wavelength of the light beam, and a function of transmitting the detected wavelength of the light beam to the calculator 124. Note that the light beam emitted from the exposure light source 402 is used as exposure light for exposing a wafer 412, or measurement light for measuring the imaging performance of the projection optics 410.

The incoherent optics 404 makes the light beam from the exposure light source 402 incoherent (i.e., reduces the spatial coherence of the light beam).

The illumination optics 406 illuminates a reticle 408 and the object plane side measurement mask 422 set on the object plane of the projection optics 410. The illumination optics 406 includes a lens, mirror, optical integrator, and aperture stop.

The reticle 408 has a pattern (circuit pattern) to be transferred onto the wafer 412, and is supported and driven by a reticle stage (not shown). Note that this reticle stage (not shown) supports the reticle 408 and object plane side measurement mask 422, and interchangeably sets the reticle 408 and object plane side measurement mask 422 on the object plane of the projection optics 410.

The projection optics 410 projects the pattern of the reticle 408 onto the wafer 412. The projection optics 410 has a driving element DE for driving an optical element OE with respect to the reference plane of a barrel, in order to adjust (optimize) the imaging performance.

The wafer 412 is a substrate onto which the pattern of the reticle 408 is projected (transferred), and supported and driven by a wafer stage (not shown). Note that this wafer stage (not shown) supports the wafer 412 and image plane side measurement mask 426, and interchangeably sets the wafer 412 and image plane side measurement mask 426 on the image plane of the projection optics 410.

During exposure, the light beam emitted by the exposure light source 402 illuminates the reticle 408 via the incoherent optics 404 and illumination optics 406. The light beam having passed through the reticle 408 and reflecting the pattern of the reticle 408 forms an image on the wafer 412 via the projection optics 410.

Measurement of the imaging performance of the projection optics 410 in the exposure apparatus 400 will be explained below. This embodiment will be explained by taking the case in which the wavefront aberration is measured as the imaging performance of the projection optics 410 as an example.

The light beam emitted by the exposure light source 402 enters the illumination optics 406 after the spatial coherence is reduced by the incoherent optics 404. The light beam having entered the illumination optics 406 illuminates the object plane of the projection optics 410 by an appropriate illumination mode.

When measuring the wavefront aberration of the projection optics 410, the object plane side measurement mask 422 having a pinhole and opening in a measurement object height position is set on the object plane of the projection optics 410. Also, the diffraction grating 424 for branching the light beam from the illumination optics 406 is set above the object plane side measurement mask 422. Note that the object plane side measurement mask 422 and diffraction grating 424 have a positional relationship by which two diffracted light components (diffracted light components having different orders) diffracted by the diffraction grating 424 pass through the opening and pinhole of the object plane side measurement mask 422. The pinhole of the object plane side measurement mask 422 is formed to have an opening diameter equal to or smaller than the diffraction limit of the projection optics 410. The light having passed through this pinhole enters the projection optics 410 after being shaped into an ideal spherical wave.

The two diffracted light components having passed through the projection optics 410 enter the image plane side measurement mask 426 set on the image plane of the projection optics 410. The image plane side measurement mask 426 has a pinhole and opening. The diffracted light component having passed through the opening of the object plane side measurement mask 422 passes through the pinhole of the image plane side measurement mask 426 and becomes a reference light beam. On the other hand, the diffracted light component having passed through the pinhole of the object plane side measurement mask 422 passes through the opening of the image plane side measurement mask 426 and becomes a light beam to be detected.

The pinhole of the image plane side measurement mask 426 is formed to have an opening diameter equal to or smaller than the diffraction limit of the projection optics 410, and shapes the wavefront of the reference light beam into an ideal spherical wave. Also, the opening of the image plane side measurement mask 426 has an opening diameter much larger than a point image intensity distribution formed by the projection optics 410. Therefore, light can pass through the opening without losing the wavefront aberration information of the projection optics 410. Accordingly, the light beam to be detected is shaped into an ideal spherical wave before entering the projection optics 410, and passes through the opening via the projection optics 410 without losing the wavefront aberration information. This makes the wavefront of the light beam to be detected equal to the wavefront aberration of the projection optics 410.

The image sensing element 122 supported by the wafer stage is placed below the image plane side measurement mask 426, and takes an image of the interference pattern of the light beam to be detected and the reference light beam. Since the light beam to be detected and the reference light beam have different image point positions, the interference pattern captured by the image sensing element 122 has a tilt fringe. By using this tilt fringe, the calculator 124 calculates the wavefront aberration of the projection optics 410 from the interference pattern by using the electronic moire method, FFT method, or the like.

The wavefront aberration of the projection optics 410 thus calculated is the wavefront aberration of the projection optics 410 in the measurement environment. Generally, physical quantities in the initial state in which the projection optics 410 is incorporated into the exposure apparatus 400 and physical quantities in a state immediately after a member related to the imaging performance of the projection optics 410 is replaced differ from physical quantities (in the exposure environment) that optimize the imaging performance of the projection optics 410. Therefore, the calculator 124 calculates physical quantities that optimize the imaging performance of the projection optics 410, based on the imaging performance of the projection optics in a nominal environment, information indicating the rate of change of the imaging performance of the projection optics with respect to physical quantities that change the imaging performance, and physical quantities in the nominal environment.

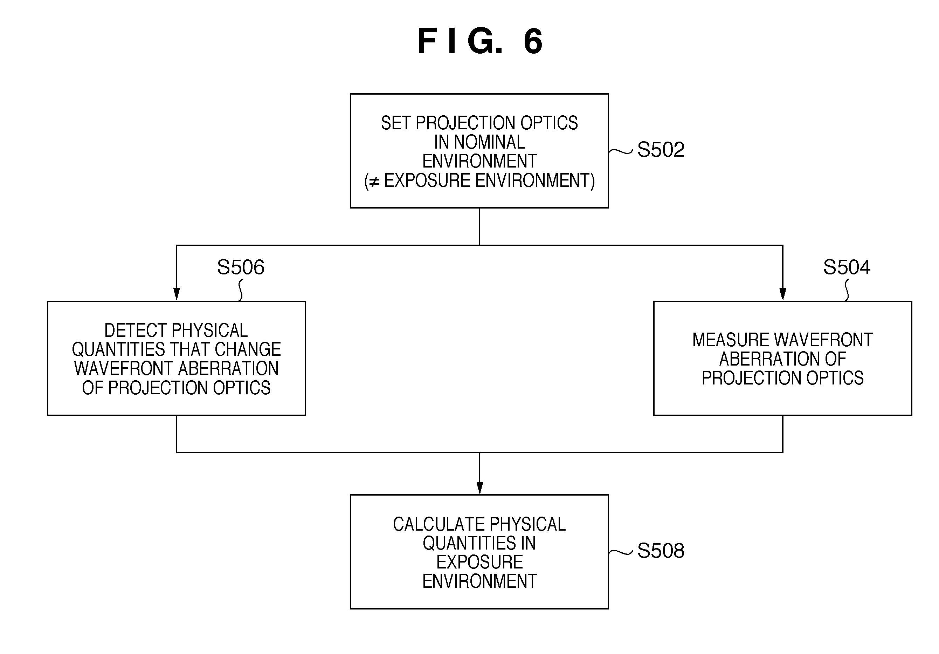

Fig. 6 is a flowchart showing details of the method of measuring the wavefront aberration of the projection optics 410 in the exposure apparatus 400.

First, in step S502, the projection optics 410 is controlled to attain the nominal environment.
In this embodiment, the position of the optical element OE of the projection optics 410 and the wavelength of the light beam emitted from the exposure light source 402 are controlled to be constant at predetermined nominal values. Note that the nominal environment does not always match the use environment (exposure environment) of the projection optics 410.

Then, in step S504, the wavefront aberration of the projection optics 410 is measured in the nominal environment controlled in step S502. Also, in step S506, the physical quantities that change the imaging performance of the projection optics 410 (i.e., the physical quantities in the nominal environment) are detected in the nominal environment controlled in step S502. More specifically, the internal temperature and pressure of the projection optics 410, the position of the optical element OE in the projection optics 410, and the like are detected as the physical quantities in the nominal environment.

Subsequently, in step S508, the physical quantities (in the exposure environment) that give an optimum value to the wavefront aberration of the projection optics 410 are calculated. More specifically, the physical quantities in the exposure environment are calculated based on the wavefront aberration of the projection optics 410 measured in step S504, the physical quantities in the nominal environment detected in step S506, and the sensitivity to preacquired physical quantities. In this embodiment, the wavelength of the exposure light emitted by the exposure light source 402 and the position of the optical element OE of the projection optics 410 by which an optimum value is given to the wavefront aberration of the projection optics 410 are calculated as the physical quantities in the exposure environment. The optimum value of the wavefront aberration can be, for example, the smallest value within the range over which the wavelength of the exposure light and the position of the optical element are adjustable.

When calculating the wavelength of the exposure light and the position of the optical element, it is possible to use values calculated based on design values of the projection optics as the sensitivity of the imaging performance to changes in exposure light wavelength and optical element position. Also, when calculating the wavelength of the exposure light and the position of the optical element, it is necessary to take account of the change in imaging performance produced by the differences between the internal temperature and pressure of the projection optics in the nominal environment detected in step S506 and those of the projection optics in the exposure environment. Note that the wavefront aberration of the projection optics 410 in the exposure environment is also calculated when calculating the wavelength of the exposure light and the position of the optical element in the exposure environment.

Note that the exposure apparatus 400 adjusts the physical quantities based on the physical quantities calculated in step S508. More specifically, the exposure light source 402 and optical element controller 130 are controlled to give an optimum value to the wavefront aberration of the projection optics 410, thereby adjusting the wavelength of the light beam emitted from the exposure light source 402 and the displacement of the optical element OE of the projection optics 410. Accordingly, the exposure light source 402 and optical element controller 130 function as an adjusting unit for adjusting the imaging performance of the projection optics 410. Since the wavefront aberration (imaging performance) of the projection optics 410 used by the exposure apparatus 400 is thus accurately adjusted, high imaging performance is achieved. Consequently, the exposure apparatus 400 can economically provide high-quality devices (e.g., semiconductor devices and liquid crystal display devices) with high throughput. Note that the device is fabricated through a step of exposing a substrate (e.g., a wafer or glass plate) coated with a photoresist (photosensitive agent) by using the exposure apparatus 400, a step of developing the exposed substrate, and other well-known steps.

While the present invention has been described with reference to exemplary embodiments, it is to be understood that the invention is not limited to the disclosed exemplary embodiments. The scope of the following claims is to be accorded the broadest interpretation so as to encompass all such modifications and equivalent structures and functions. The present invention provides a measurement method of measuring imaging performance of a projection optics which projects a reticle pattern onto a substrate, including a measurement step of measuring the imaging performance of the projection optics, and a calculation step of calculating the imaging performance of the projection optics in a predetermined environment different from a measurement environment in which the measurement step is performed, based on information indicating a rate of change of the imaging performance of the projection optics with respect to a physical quantity which changes the imaging performance of the projection optics, a physical quantity in the measurement environment, a physical quantity in the predetermined environment, and the imaging performance of the projection optics measured in the measurement step.

## Claims

1. A measurement method of measuring imaging performance of a projection optics which projects a reticle pattern onto a substrate, comprising:

   a measurement step of measuring the imaging performance of the projection optics; and
   a calculation step of calculating the imaging performance of the projection optics in a predetermined environment different from a measurement environment in which the measurement step is performed, based on information indicating a rate of change of the imaging performance of the projection optics with respect to a physical quantity which changes the imaging performance of the projection optics, a physical quantity in the measurement environment, a physical quantity in the predetermined environment, and the imaging performance of the projection optics measured in the measurement step.

2. The method according to claim 1, further comprising a detection step of detecting the physical quantity in the measurement environment.

3. The method according to claim 1, wherein in the calculation step, an amount of change of the imaging performance of the projection optics in the measurement environment from the imaging performance of the projection optics in the predetermined environment is calculated based on a difference between the physical quantity in the measurement environment and the physical quantity in the predetermined environment, and the imaging performance of the projection optics in the predetermined environment is calculated by adding or subtracting the amount of change to or from the imaging performance of the projection optics measured in the measurement step.

4. The method according to claim 1, wherein the physical quantity which changes the imaging performance of the projection optics includes at least one of a wavelength of light entering the projection optics, an internal atmospheric pressure of the projection optics, an internal temperature of the projection optics, and a displacement of an optical element forming the projection optics.

5. The method according to claim 1, further comprising a holding step of holding an optical element forming the projection optics by a holding unit which fixes the optical element in a predetermined position,
   wherein the position of the optical element held by the holding unit is used as the physical quantity which changes the imaging performance of the projection optics.

6. The method according to claim 1, wherein the information indicating the rate of change of the imaging performance of the projection optics with respect to the physical quantity which changes the imaging performance of the projection optics is calculated from a design value of the projection optics.

7. The method according to claim 1, wherein the information indicating the rate of change of the imaging performance of the projection optics with respect to the physical quantity which changes the imaging performance of the projection optics is obtained by measuring a change amount of the imaging performance of the projection optics while changing the physical quantity which changes the imaging performance of the projection optics.

8. A measurement apparatus for measuring imaging performance of a projection optics which projects a reticle pattern onto a substrate, comprising:

a measurement unit configured to measure the imaging performance of the projection optics; and
a calculator configured to calculate the imaging performance of the projection optics in a predetermined environment different from a measurement environment in which said measurement unit performs measurement, based on information indicating a rate of change of the imaging performance of the projection optics with respect to a physical quantity which changes the imaging performance of the projection optics, a physical quantity in the measurement environment, a physical quantity in the predetermined environment, and the imaging performance of the projection optics measured by said measurement unit.

9. The apparatus according to claim 8, further comprising a storage unit configured to store the information indicating the rate of change of the imaging performance of the projection optics with respect to the physical quantity which changes the imaging performance of the projection optics.

10. An exposure apparatus comprising:

a projection optics configured to project a reticle pattern onto a substrate;
a measurement unit configured to measure imaging performance of said projection optics;
a calculator configured to calculate, in an exposure environment, a physical quantity which changes the imaging performance of said projection optics, based on information indicating a rate of change of the imaging performance of said projection optics with respect to the physical quantity, the physical quantity in a measurement environment in which said measurement unit performs measurement, and the imaging performance of said projection optics measured by said measurement unit; and
an adjusting unit configured to adjust a wavelength of light entering said projection optics or a displacement of an optical element forming said projection optics, based on the physical quantity in the exposure environment calculated by said calculator.

11. A device fabrication method comprising steps of:

exposing a substrate using an exposure apparatus according to claim 10; and
performing a development process for the substrate exposed.

FIG. 1

# F I G. 2

SET PROJECTION OPTICS
IN MEASUREMENT
ENVIRONMENT
(≠ EXPOSURE ENVIRONMENT) — S202

DETECT PHYSICAL
QUANTITIES THAT CHANGE
IMAGING PERFORMANCE
OF PROJECTION OPTICS — S206

MEASURE IMAGING
PERFORMANCE OF
PROJECTION OPTICS — S204

CALCULATE IMAGING
PERFORMANCE OF
PROJECTION OPTICS IN
EXPOSURE ENVIRONMENT — S208

EP 2 109 002 A2

1A

F I G. 3

EP 2 109 002 A2

15

# F I G. 4

SET PROJECTION OPTICS
IN MEASUREMENT
ENVIRONMENT
(≠ EXPOSURE ENVIRONMENT) ⸝ S302

S308

S306

S304

OBTAIN DISPLACEMENT
OF OPTICAL ELEMENT
OF PROJECTION OPTICS

DETECT PHYSICAL
QUANTITIES THAT CHANGE
IMAGING PERFORMANCE
OF PROJECTION OPTICS

MEASURE IMAGING
PERFORMANCE OF
PROJECTION OPTICS

CALCULATE IMAGING
PERFORMANCE OF
PROJECTION OPTICS IN
EXPOSURE ENVIRONMENT ⸝ S310

EP 2 109 002 A2

F I G. 5

400

# F I G. 6

SET PROJECTION OPTICS
IN NOMINAL
ENVIRONMENT
(≠ EXPOSURE ENVIRONMENT) — S502

DETECT PHYSICAL
QUANTITIES THAT CHANGE
WAVEFRONT ABERRATION
OF PROJECTION OPTICS — S506

MEASURE WAVEFRONT
ABERRATION OF
PROJECTION OPTICS — S504

CALCULATE PHYSICAL
QUANTITIES IN
EXPOSURE
ENVIRONMENT — S508

EP 2 109 002 A2

FIG. 7

# F I G. 8

SET PROJECTION OPTICS IN
THE SAME STATE AS THAT
OF USE ENVIRONMENT
(EXPOSURE ENVIRONMENT)

S2002

MEASURE IMAGING
PERFORMANCE OF
PROJECTION OPTICS

S2004

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 1123238 A